# EUROPEAN PATENT SPECIFICATION

(11) **EP 3 028 548 B1**
(45) Date of publication and mention of the grant of the patent: **07.10.2020**
(21) Application number: 14772441.3
(22) Date of filing: 03.08.2014
(51) Int. Cl.: H05K 3/10, H05K 1/09

(54) **COMPOUND TO FORM ELECTRICAL TRACKS INTO**
VERBINDUNG ZUR FORMUNG ELEKTRISCHER SPUREN
COMPOSÉ POUR FORMER DES PISTES ÉLECTRIQUES

(30) Priority: 03.08.2013 IT TV20130128
(43) Date of publication of application: 08.06.2016
(73) Proprietor: Tryonic Ltd, London, Greater London (GB)
(72) Inventor:
(74) Representative: Citron, Massimiliano
(86) International application number: PCT/IB2014/063658
(87) International publication number: WO 2015/019266

(56) References cited:
- JP-A- 2003 198 100
- JP-A- 2007 258 577
- US-A1- 2006 275 705

## Description

The invention concerns a compound, e.g. to be spread or sprayed on any surface, in which to realize conductive circuits or tracks to carry electrical charges, or voltage or current signals. The compound is modifiable to locally vary its electrical conductivity.

To wire surfaces or equipments is known to be a very expensive and laborious operation. The length of the cables, their cost and weight often account for a predominant part, sometimes up to advise against the beginning of the work.

WO/2012/137048, for example, teaches how to create conductive paths inside the volume of a compound, thanks to polarizable molecules via laser. The compound here, however, has a complex formula, and the use of a laser can disadvantageously limit the areas of application.

This raises the problem of obtaining a compound of the aforementioned type which has a simple formula, and therefore inexpensive and easily reproducible.

JP 2007 258577, US 2006/275705 and JP 2003 198100 disclose a method for making electrically conductive tracks or areas within a cellulose by a laser. The material comprises metal particles with an average diameter equal to or less than 3 µm.

At least one problem is solved by the compound and/or method as in the attached claims, in which the dependent ones define advantageous variants.

Percentages described below are percentages by weight with respect of the total, unless otherwise specified.

Cellulose (C₆H₁₀O₅) and the class of substances derived from it proved to be a good material in which to obtain electrically conductive tracks. In particular, advantageous is the difference (decrease) of electrical resistivity which is obtained by burning or heating a portion of cellulose making it carbonize.

In particular, it was unexpectedly found that the nitrocellulose, a cellulose subspecies, provides the results of lower resistivity than the cellulose, therefore electrical paths of better quality. And it is also more easily sprayable and diluted, so it can be vaporized better and more easily.

Nitrocellulose (or cellulose) generally has a resistivity of an insulator at room temperature. Taking it approximately to 220-230 °C it carbonizes, and its resistivity drops in the range of semiconductors. The change in electrical resistance for more electrically conductive tracks or areas is exploited to create e.g. conductive pathways *ad hoc, ex novo* or in real time, or to manage logical states represented by voltages or currents.

Preferably to locally raise the temperature of the cellulose or nitrocellulose in order to carbonize it and trace the track, a laser is used, which gives comfort and precision tracing. But one can also use other methods of heating/tracing, e.g. by putting in the oven or burning with a heat source sections of (nitro)cellulose, e.g. the hot rod of a tin-plater. Burning, however, operates in a poorly controlled way, the results are not repeatable with high precision, but for medium accuracy is sufficient.

For example, in the laboratory on an insulating base was spread a layer of nitrocellulose, and on it (see below how) a 7 cm long, 0.9 mm wide and about 7 mµ deep track, was derived. The layer of nitrocellulose was 50 µm thick and above it a laser beam was run. From a virtually infinite resistivity the nitrocellulose track has come to a resistance of 3500 Ω.

Advantageously with the same results each type of nitrocellulose can be used, e.g. mononitric (C₂₄H₃₉(NO₂)₁₂O₂₀), binitric, trinitric, etc, up to dodecanitric (C₂₄H₂₈(NO₂)₁₂O₂₀.

To improve the electrical performance, to the material particles of noble materials are added (e.g. silver, copper, gold, platinum, indium, tungsten). Gold has high costs, and except for silver all the others work with lower performance. The addition of these particles has yielded surprising results. Even though they are a conductive material themselves, the mere introduction of the particles in the material would not lead to an increase of the total electrical conductivity, due to a layer of insulating oxide that inevitably forms around each particle. However, the conductivity actually improves, provided that the particle size and/or their density have certain values. The best results were obtained with particles, in particular silver particles, with an average diameter of 5 µm to 17 µm, with a conductivity peak detected for diameters of 9 µm to 11 µm. The average or optimal particle size or diameter is preferably 11 µm, for example with a composition of the particles equal to: 34% with a diameter of 12-18 µm; 50% with a diameter of 11 µm; 16% with a diameter of 3-5 µm.

In particular for silver powder or silver particles, the percentage by weight of 3% to 20%, even more in particular 5% to 12%, have allowed to obtain good electronic performance.

The effect is explained theoretically considering that by the local increase of temperature the oxide layer explodes and its fragments remain near the core of the particle. On the various exposed nuclei an electron cloud would form being large enough to communicate electronically with the near one, from this the improved conductivity.

Preferably the compound or material is applied to a surface by a brush, spraying or cold drawing. In order to favor the application, to the mixture a solvent is added, which acts as a diluent and then evaporates after spraying. One can use e.g. dichloromethane, or organic solvents (e.g. tetrachlorethylene, acetone, methyl acetate, ethyl acetate, hexane).

Preferably to the compound a glycol is added, e.g. PEG (polyethylene glycol). A percentage that has given good results is 1-4%.

The effect is to keep soft or flexible the compound when the solvent is evaporated, in order to avoid cracks or lesions when the support is deformed or there are e.g. temperature excursions. It is also possible to mechanically deform the layer of compound when or almost solidified, allowing e.g. the movement of movable elements inside it.

Preferably, to the compound a (food or acrylic) dye is added; with a percentage that has given good results of about 2%. So the laser absorption for the compound is improved. The laser could go through the compound without heating or burning it, and/or without acting on the particles made of noble material (v. below).

It is also proposed a method for making electrically conductive tracks or areas within a material. The method shares the advantages already described for the compound, and vice versa. The method is characterized by the steps of
using as material cellulose or its derivatives;
locally raising the temperature of a portion of the material.

A laser is used to locally raise the temperature of a portion of the material and in the material silver or copper or gold or platinum or indium or tungsten particles are inserted, having an average diameter of 5 µm to 17 µm, and percentage by weight with respect to the material that contains them of 3% to 20%;

As optional steps of the method, either alone or in combination:
- nitrocellulose is used for material;
- said average diameter is 10-11 µm;
- a glycol is added, e.g. PEG (polyethylene glycol), to the material;
- a solvent is added, e.g. diethyl ether, to the material;
- a food or acrylic dye is added to the material.

Note that the aforementioned rise in temperature in the material can only serve to carbonize it and increase its electrical conductivity. A first effect is therefore an increase of conductivity of the material. Further drops of resistivity are achieved through the interaction of the laser with particles dispersed in the cellulose, see below. The localized supply of heat and energy, therefore, can act also on the dispersions within the matrix of cellulose, and the resistivity is even lower just because of the fact that such dispersions are within the cellulose. The said compound also allows a tracing of the track in an automatic way: when a voltage is applied between two points of the compound a track will form between them.

The advantages of the invention will be clearer from the following description of a preferred embodiment of the compound, making reference to the attached drawing in which
Fig. 1 shows a layer composed as laid down;
Fig. 2 shows a magnification of the compound of Fig. 1;
Fig. 3 shows the compound of Fig. 3 in particular configuration;
Fig. 4 shows particles present in the layer of Fig. 1.

On a generic support surface 10, e.g. a wall, a metallic body, a printed circuit board (PCB) or a layer of glass, polyacetate or acrylic, there is spread or sprayed a layer 20 of compound.

The compound 20 can be formed like this (by volume):
- 16% of micrometric silver powder (with a particle size as specified above)
- 40% collodion (6% solution of nitrocellulose in ethanol or a ethanol/diethylether mixture);
- 40% diluent, where the diluent is composed of: 76% butyl acetate, 12% ethanol, 8% toluene, 4% ethylcellulose;
- 2-4% PEG;
- 2% (optional) of additive sensitizer to optimize the irradiation by laser light, e.g. pigment red 112, iupac name: 2-Naphthalenecarboxamide, 3-hydroxy-N-(2-methylphenyl) - 4 - [(2,4,5-trichlorophenyl) azo].

Another formulation of the compound 20, the most simple, can be:
- 97% to 80% nitrocellulose;
- silver powder or silver particles: 3% to 20%, or better 5% to 12%, to obtain good electronic performance.

The nitrocellulose in the previous example (by its unit of weight) is regarded as commercially purchased, and can contain other components that constitute the said solvent, e.g. 98% to 90% diethyl ether + methanol, or 35% to 70% diethyl ether + 65% to 30% methanol, and 2% to 10% semi-synthetic cellulose. For example, exact values in the nitrocellulose are: nitrocellulose 6% and ethyl ether + methanol 94%. The percentage of solvent is not critical, however.

The values quoted for the doses of the various components of the compound are those resulted optimal experimentally, but individual percentage changes are possible, e.g. by ± 15%.

In general then a generic formula can be:
nitrocellulose: 2% to 10%;
silver powder or silver particles (as described before): 3% to 20%, or better 5% to 12% to obtain good electronic performance,
remaining %: solvent as described before.

The production of the compound does not require special care, it is enough to put the components together and mix them. For example, the components may be mixed directly in the tank of an airbrush, e.g. by the agitation of a magnet. Or the nitrocellulose is mixed with the PEG, the solvent is added, blending, and finally one adds the dye (optional).

Once laid, the compound 20 dries and hardens in 3-5 minutes; or one can bake it at about 80 °C for 5-6 seconds.

For the silver particles or powder (or other noble material), one can use what is commercially available (e.g. by firm Heraeus Precious Metals GmbH & Co. KG).

The particle diameter can range from some µm to a few dozen mµ, and the best experimental results were obtained with a diameter, also average diameter, of about 10-11 µm. An experimented case with average diameter of 10 µm had the following particle size for the particles: 34% at 12-18 µm; 50% at 11 µm; 16% at 3-5 µm = average value 11 µm or 7 µm, with all values comprised within this range.

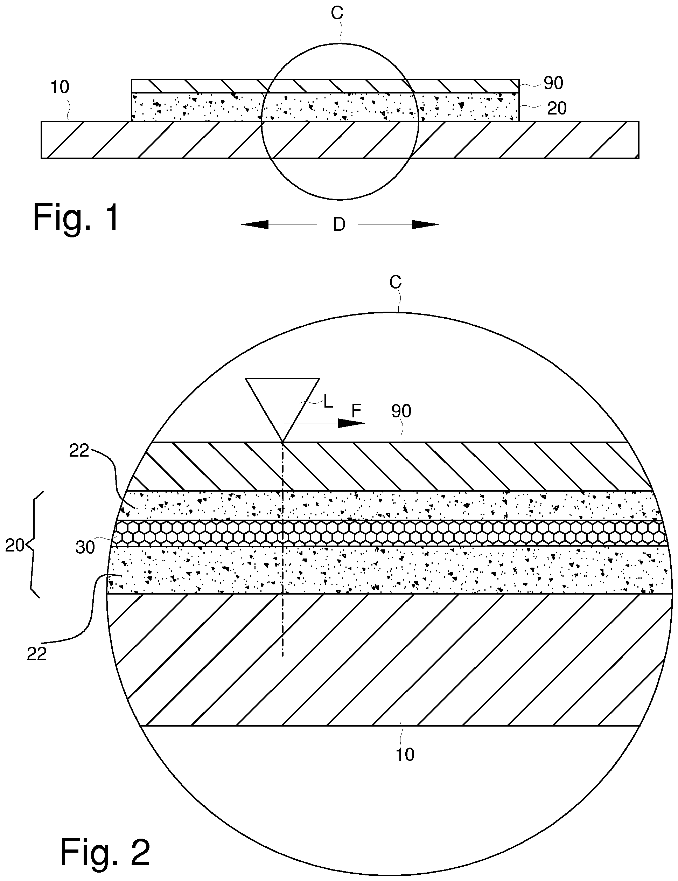

After spraying of the compound 20, the silver particles are distributed forming a layer 30 fairly uniform inside the layer of cellulose 22 (fig. 2). The weight of silver is not sufficient to get it to fall completely towards the support 10, so it floats on the nitrocellulose thanks to the greater molecular size of the latter. If the particles have a diameter less than 5 or 6 µm the tracks in the compound begin to lose the conductivity characteristics, or one is unable to create them. Not only are the particles "floating" on the (nitro)cellulose (which prevents tracks inside its volume), but even doing a superficial, mono-track sample the electrical conduction is poor because the electronic clouds are small. If the particles are too large, however, they sink before the (nitro)cellulose creates a lattice and the layer 30 does not come out. In other words the ranges of value for the particle size within which the compound works must be - surprisingly - respected with good precision. Greater or lesser values have been tried experimentally but satisfactory results have not been obtained. The reason is that there is precipitation on the bottom of the compound when the particles are too large or they do not fall inside the compound when they are too small.

On a layer of compound 20 with a thickness of 50 µm the layer 30 of silver arranges at about 35 µm from the support 10, and is about 7 µm thick.

Then a laser L is run over. The laser beam is sent in the compound 20, in the direction substantially perpendicular to the largest dimension D of the support 10, and it moves along the layer 20 to create a track (direction F).

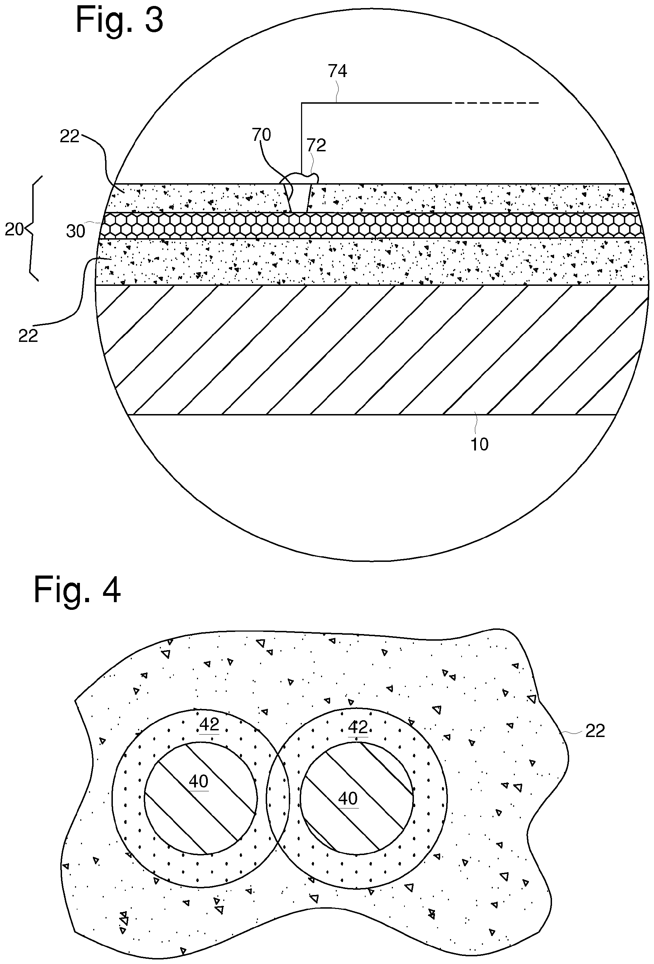

The laser L has focal length such as to reach and act on the layer of particles. It breaks down and blows off the oxide layer that surrounds the particles. Then, around a particle of silver 40 (fig. 4) an electron cloud 42 will form that on average manages to touch that of a neighboring particle. Even if the particles 40 are separated by a micrometric segment of carbonized nitrocellulose (on average 2-3 µm), and thus still more conductive than before the laser L passed, the segment is shunted in parallel by the cloud 42, and the overall conductivity of the layer 30 becomes unexpectedly much higher.

Putting a lot of particles degrades performance, because the layer 30 becomes a nearly uniform and indistinct diffusion in the volume of (nitro)cellulose.

In the laboratory, samples were prepared for experimenting the tracing by depositing the compound 20 on different plastic substrates. The compound 20 was applied by spraying, in five successive coats.

Usually 80% of the solvent leaves by evaporation, and there remain 50 µm of compound (nitrocellulose + silver + 10% solvent).

The final thickness of the layer of deposited compound 20 was about 200 µm. A 4 cm long, 1 mm wide and thickness of average 7 microns track was traced, with the greater particle size of silver.

### Polyethylene film:

Resistance of the track: 2 ohms (Dielectric greater than 1 GΩ).

### Silicone rubber (reinforced with carbon fibers):

Conductivity of the track after the passage of the laser L: 2 Ω (Dielectric greater than 1 GΩ).

Excellent adhesion of the compound on the support.

### Epoxy resin (Epichlorohydrin + BFA) reinforced with carbon fibers:

Conductivity of the track after the passage of the laser L: 2 Ω (Dielectric greater than 1 GΩ).

### Polystyrene:

Conductivity of the track after the passage of the laser L: 2 Ω (Dielectric greater than 1 GΩ).

The best conductivity was experimented with particles 40 having diameter, also average diameter, of 10 µm, and/or with an empty/full ratio between nitrocellulose and particles 40 of about 0.5.

As laser L a laser was used at 480 µm with a 27-28 mm focal. It is preferred that the specific power of the laser is 0.6 W/mm*s, and that the laser moves with the speed of 1 mm/sec (direction F).

For protection, one can overlap the traced compound 20 with a protective layer 90, for example acrylic or polyvinyl-alcohol (which also absorbs any residual water captured by the compound 20 during spraying).

To create multiple layers of overlapping tracks one can spray a layer 20, create a track in it, overspray another layer 20, create a track in it, and so on. Between a layer 20 and the next one, the protective layer 90 can be inserted.

To access the traced track one can pierce the layer 20 (fig. 3), e.g. by a laser, to open a channel 70 in the nitrocellulose until reaching the track in the layer 30 of particles. Into the channel 70, for example with a syringe or dispensing element, silver or liquid conductive material is poured and a conductive connection 74 is immersed therein. The liquid conductive material solidifies and permanently connects the inner track to the outside.

## Claims

1. Method for making electrically conductive tracks or areas within a material (20), **characterized by**
- using as material cellulose (22) or its derivatives;
- locally raising the temperature of a portion of the material to carbonize it and trace a track,
**characterized in that**
- silver or copper or gold or platinum or indium or tungsten particles (40) are inserted in the material,
the particles having an average diameter from 5 µm to 17 µm, and percentage by weight, with respect to the material that contains them, from 3% to 20%;
- a laser (L) beam locally raises the temperature of a portion of the material to break down and blow off an oxide layer that surrounds the particles.

2. Method according to claim 1, wherein the average particle size or diameter is 11 µm.

3. Method according to claim 2, wherein the composition of the particles is equal to: 34% with a diameter of 12-18 µm; 50% with a diameter of 11 µm; 16% with a diameter of 3-5 µm.

4. Method according to claim 1 or 2 or 3, wherein the material is nitrocellulose.

5. Method according to any one of the preceding claims, wherein a glycol, e.g. PEG (polyethylene glycol), is added to the material, and/or a solvent, e.g. ethyl ether, is added to the material.

6. Method according to any one of the preceding claims, wherein a solvent is added, e.g. diethyl ether, to the material.

7. Method according to any one of the preceding claims, wherein a food or acrylic dye is added to the material.

8. Method according to any one of the preceding claims, wherein the material is applied to a surface by a brush, spraying or cold drawing.

9. Compound (20) inside which to form electrically conductive tracks or areas, **characterized by** comprising by weight
• cellulose (22) or a derivative of it: from 2% to 10%;
• particles (40) of silver or copper or gold or platinum or indium or tungsten, having an average diameter from 5 µm to 17 µm, in particular from 5% to 12%, and percentage by weight from 3% to 20%;
• solvent, e.g. diethyl ether: the remaining %.

10. Compound according to claim 9, wherein the derivative is nitrocellulose.

11. Compound according to claim 9 or 10, wherein the average diameter is 10-11 µm.

12. Compound according to any one of the preceding claims, comprising a glycol, e.g. PEG (polyethylene glycol), e.g. 2-4%.

13. Compound according to any one of the preceding claims, comprising a solvent, e.g. dichloromethane, or organic solvents as tetrachlorethylene, acetone, methyl acetate, ethyl acetate, hexane.

14. Compound according to any one of the preceding claims, comprising a a food or acrylic dye with a percentage of about 2%.

## Patentansprüche

1. Methode zur Realisierung elektrisch leitender Bahnen oder Bereiche innerhalb eines Materials (20), **dadurch gekennzeichnet, dass** es
- Cellulose (22) oder deren Derivate als Material verwendet;
- die Temperatur eines Teils des Materials lokal erhöht;
**dadurch gekennzeichnet, dass**
- Partikeln (40) aus Silber oder Kupfer oder Gold oder Platin oder Indium oder Tungsten mit einem mittleren Durchmesser von 5 µm bis 17 µm und mit einem Gewichtsprozent von 3% bis 20% in Bezug auf das diese enthaltenden Material in das Material eingeführt werden,
- ein Laser (L) die Temperatur eines Teils des Materials lokal erhöht, um eine Oxidschicht zu brechen und zu explodieren, die die Partikeln einwickelt.

2. Methode nach Anspruch 1, wobei der mittlere Durchmesser der Partikeln 10 µm beträgt.

3. Methode nach Anspruch 2, wobei die Zusammensetzung der Partikeln beträgt: 34% mit einem Durchmesser von 12-18 µm; 50% mit einem Durchmesser von 11 µm; 16% mit einem Durchmesser von 3-5 µm.

4. Methode nach Anspruch 1 oder 2 oder 3, wobei das Material Nitrocellulose ist.

5. Methode nach einem vorhergehenden Anspruch, wobei ein Glykol, z.B. PEG (Polyethylenglykol), dem Material zugesetzt wird und / oder ein Lösungsmittel, z.B. Diethylether, dem Material zugesetzt wird.

6. Methode nach einem vorhergehenden Anspruch, wobei ein Lösungsmittel, z.B. Diethylether, dem Material zugesetzt wird.

7. Methode nach einem vorhergehenden Anspruch, wobei ein Lebensmittel- oder Acrylfarbstoff dem Material zugesetzt wird.

8. Methode nach einem vorhergehenden Anspruch, wobei das Material durch einen Pinsel durch Sprühen oder Kaltauftragen auf eine Oberfläche aufgetragen wird.

9. Verbindung (20), in dessen Innerem elektrisch leitende Bahnen oder Bereiche erzeugt werden sollen, **dadurch gekennzeichnet, dass** sie Gew.-% umfasst
• Cellulose (22) oder deren Derivat: 2% bis 10%;
• Partikeln (40) aus Silber oder Kupfer oder Gold oder Platin oder Indium oder Tungsten mit einem mittleren Durchmesser von 5 µm bis 17 µm, insbesondere von 5% bis 12% und Gewichtsprozent von 3% bis 20%;
• Lösungsmittel, z.B. Diethylether: restliche %.

10. Verbindung nach Anspruch 9, wobei das Derivat Nitrocellulose ist.

11. Verbindung nach Anspruch 9 oder 10, wobei der mittlere Durchmesser 10-11 µm beträgt.

12. Verbindung nach einem vorhergehenden Anspruch, umfassend ein Glykol, z.B. PEG (Polyethylenglykol), z.B. 2-4%.

13. Verbindung nach einem vorhergehenden Anspruch, umfassend ein Lösungsmittel, z.B. Dichlormethan oder organische Lösungsmittel wie Tetrachlorethylen, Aceton, Methylacetat, Ethylacetat, Hexan.

14. Verbindung nach einem vorhergehenden Anspruch, umfassend ein Lebensmittel- oder Acrylfarbstoff mit einem Prozentsatz von etwa 2%.

## Revendications

1. Procédé pour créer des pistes ou des zones électriquement conductrices à l'intérieur d'un matériau (20), **caractérisé en ce qu'**il est constitué de
- l'utilisation comme matériau de la cellulose (22) ou ses dérivés ;
- l'augmentation locale de la température d'une partie du matériau ;
**caractérisé en ce que**
- des particules (40) d'argent ou de cuivre ou d'or ou de platine ou d'indium ou de tungstène, ayant un diamètre moyen de 5 µm à 17 µm, sont insérées dans le matériau, et ayant un pourcentage en poids par rapport au matériau les contenant de 3% à 20%,
- un laser (L) élève localement la température d'une partie du matériau pour casser et faire exploser une couche d'oxyde qui enveloppe les particules.

2. Procédé selon la revendication 1, où le diamètre moyen des particules est de 10 µm.

3. Procédé selon la revendication 2, où la composition des particules est égale à : 34% avec un diamètre de 12-18 µm ; 50% avec un diamètre de 11 µm ; 16% avec un diamètre de 3-5 µm.

4. Procédé selon la revendication 1 ou 2 ou 3, où le matériau est de la nitrocellulose.

5. Procédé selon l'une quelconque des revendications précédentes, où un glycol est ajouté, par ex. du PEG (polyéthylène glycol), au matériau, et/ou un solvant est ajouté, par ex. de l'éther éthylique, au matériau.

6. Procédé selon l'une quelconque des revendications précédentes, où un solvant est ajouté, par ex. de l'éther éthylique, au matériau.

7. Procédé selon l'une quelconque des revendications précédentes, où un colorant alimentaire ou acrylique est ajouté au matériau.

8. Procédé selon l'une quelconque des revendications précédentes, où le matériau est appliqué sur une surface avec un pinceau, par pulvérisation ou pose à froid.

9. Composé (20) où créer des pistes ou des zones électriquement conductrices à l'intérieur, **caractérisé par le fait qu'**il comprend en poids
• de la cellulose (22) ou son dérivé : de 2% à 10% ;
• des particules (40) d'argent ou de cuivre ou d'or ou de platine ou d'indium ou de tungstène, ayant un diamètre moyen de 5 µm à 17 µm, en particulier de 5% à 12%, et ayant un pourcentage en poids de 3% à 20% ;
• du solvant, par ex. de l'éther éthylique : % restant.

10. Composé selon la revendication 9, où le dérivé est de la nitrocellulose.

11. Composé selon la revendication 9 ou 10, où le diamètre moyen est de 10-11 µm.

12. Composé selon l'une quelconque des revendications précédentes, comprenant un glycol, par ex. du PEG (polyéthylène glycol), par ex. 2-4%.

13. Composé selon l'une quelconque des revendications précédentes, comprenant un solvant, par ex. le dichlorométhane ou des solvants organiques tels que le tétrachloroéthylène, l'acétone, l'acétate de méthyle, l'acétate d'éthyle, l'hexane.

14. Composé selon l'une quelconque des revendications précédentes, comprenant un colorant alimentaire ou acrylique avec un pourcentage d'environ 2%.
